# EUROPEAN PATENT SPECIFICATION

(11) **EP 0 350 873 B1**
(45) Date of publication and mention of the grant of the patent: **27.03.1996**
(21) Application number: 89112675.7
(22) Date of filing: 11.07.1989
(51) Int. Cl.: G03F 7/095

(54) **Method for forming pattern and method for making semiconductor device**
Verfahren zum Ausbilden eines Musters und Verfahren zur Herstellung einer Halbleitervorrichtung
Méthode pour la fabrication de dessins et méthode pour la fabrication d'un dispositif semi-conducteur

(30) Priority: 11.07.1988 JP 170953/88
(43) Date of publication of application: 17.01.1990
(73) Proprietor: HITACHI, LTD., Chiyoda-ku, Tokyo 100 (JP); Hitachi Chemical Co., Ltd., Shinjuku-ku, Tokyo 160 (JP)
(72) Inventor: Shiraishi, Hiroshi, Hachioji-shi (JP); Ueno, Takumi, Hachioji-shi (JP); Murai, Fumio, Nishitama-gun Tokyo (JP); Hayakawa, Hajime, Kunitachi-shi (JP); Isobe, Asao, Hitachi-shi (JP)
(74) Representative: Strehl Schübel-Hopf Groening & Partner

(56) References cited:
- US-A- 4 702 993
- DATABASE WPIL, no. 88-177833, Derwent Publication LTD, London, GB; & JP-A-63-113445
- PATENT ABSTRACTS OF JAPAN vol. 6, no. 183 (P-143)(1061) 18 September 1988, & JP-A-5796333
- PATENT ABSTRACTS OF JAPAN vol. 12, no. 276 (P-737)(3123) 30 July 1988, & JP-A- 63 56655
- PATENT ABSTRACTS OF JAPAN vol. 9, no. 253 (P-395)(1976) 11 October 1985, & JP-A- 60 103342

## Description

### BACKGROUND OF THE INVENTION

The present invention relates to formation of patterns by a multi-layer resist process, and in particular to a method for formation of a pattern of high accuracy, a resist composition used therefor and a method for making a semiconductor device by the above method.

For making a highly integrated circuit, there has been employed a so-called multi-layer resist process which uses an organic resin high in dry etching resistance as a bottom-layer resist, in order to smoothen the surface to be processed and increase dry etching resistance of the surface in processing a surface having differences in level. However, most of the hitherto used organic resin layers are insulators, and when this multi-layer resist process is applied to electron beam patterning (which is excellent in fine processability), charge is accumulated in the bottom layer during patterning, which causes turbulence of electric field of the surface of the substrate to be processed, and thus formation of a highly accurate pattern cannot be attained.

It has been attempted to reduce this charge accumulation by using, as a bottom-layer resist composition, a mixture of a synthetic resin superior in dry etching resistance and a complex salt of a polycation polymer known as conductive polymer and tetracyanoquinodimethane (Japanese Patent Kokai No. 62-113135). That is, since the bottom layer must have a sufficient dry etching resistance, the conductive polymer as it is cannot be used as a bottom layer and so the conductive polymer is mixed with a synthetic resin superior in dry etching resistance to improve conductivity. However, conductivity of the bottom layer resist composition obtained by the above process is 10¹ - 10¹⁵ S·cm⁻¹ and this value is nearly the same as that of silicate glass known as an insulator and thus the effect is considerably limitative.

As explained above, there has been found no material which possesses the properties required for the bottom-layer resist, namely, both the dry etching resistance and the high conductivity.

JP-A-63-113445 (Derwent Abstract 88-177833) discloses the formation of a patterned layer by a bi-layer resist process using a bottom resist of a radiation-induced conductive resin which comprises an additive in an amount of more than 10% by weight and a diazide, and a top layer consisting of an Si-containing resist.

### SUMMARY OF THE INVENTION

The object of the present invention is to provide a method for formation of a pattern by a multi-layer resist process which uses a charged particle beam, according to which electrification of the resist film caused by charge accumulation at the time of formation of the latent image by the charged particle beam is reduced, thereby to satisfy the required properties of the bottom-layer resist and to form a pattern of high accuracy by reducing the charge accumulation caused by patterning by the charged particle beam without much of a change in the steps for formation the resist, and to provide a resist composition and a method for making a semiconductor device using the above method for formation of patterns.

The above object can be attained by the method defined in claim 1.

As the radiation-induced conductive resin compositions, mention may be made of various photoconductive resin compositions, for example, photoconductive polymers having having many π-electrons in side chain such as poly-N-vinylcarbazole and derivatives thereof such as poly-N-vinylbromocarbazole, poly-N-vinyldibromocarbazole, poly-2-vinylcarbazole, poly-3-vinylcarbazole, and copolymers thereof, poly-l-vinylnaphthalene, polyacenaphthylene, polyvinylphenanthrene, polyvinylacridine and polyvinylpyrene, and mixtures of these photoconductive polymers with additives for improvement of photoconductivity. Polymers having many π-electrons, for example, 10 to 16 π-electrons, in side chains generally have a high dry etching resistance, and hence dry etching resistance of the bottom-layer resist can be maintained by using these polymers as resist compositions.

The charged particle beams used for formation of patterns include, for example, an electron beam and actinic radiation irradiated substantially simultaneously with the irradiation of the charged particle beam. The electromagnetic radiation (such as ultraviolet light, X-ray, and infrared light) has no effect on the charged particle beam system.

The radiation-induced conductive composition used as the bottom-layer resist is excited and becomes conductive upon irradiation with radiation such as an electron beam. Therefore, when the top-layer resist in which the latent image of a pattern is formed is irradiated with a charged particle beam, the bottom layer is simultaneously irradiated with the charge particle beam and is excited so as to become conductive and so, when the resist layer is in contact with a grounded conductive layer, accumulation of the charge induced in the top-layer resist layer by irradiation with the charged particle beam rapidly vanishes. As a result, it becomes possible to minimize the deviation from the desired position to be irradiated with a charged particle beam, since the deviation is due to the electric field produced by accumulation of charge in the resist layer.

Photoconductive polymers having many π-electrons in side chains can be used as they are as the radiation-induced conductive film. Additives are added when they are used as the bottom-layer resist. That is, for example, in an ordinary case, a middle-layer or top-layer resist is formed on the bottom layer by spin coating and so the bottom-layer resist must be insoluble in the solvent used for the coating, and thus it is effective to cross-link the radiation-induced conductive resin layer using a compound or a resin having cross-linking reactivity as the additive, thereby to make the bottom-layer resist in soluble in the solvents used. It is also effective to use additives which, in association with the photoconductive polymer having many π-electrons in side chains, can accelerate radiation-induced conductivity of this photoconductive polymer. Furthermore, it is effective to use radiation-induced luminescent compounds or surfactants for improving coatability as additives.

Additives in an amount of 10 to 70% by weight are used. Above 70% by weight, the radiation-induced conductivity and the coatability will deteriorate.

In addition, since a photoconductive composition can be used as the radiation-induced conductive composition, conductivity of the bottom-layer resist at the time of formation of the latent image of the pattern can be further improved and the minimization of charge accumulation in the top-layer resist can be further improved by adding to the apparatus for formation of pattern latent image by a charged particle beam an additional mechanism for irradiation of the surface (including the latent image forming area of a substrate) with actinic radiation which can sufficiently excite the radiation-induced conductive composition simultaneously with the irradiation by the charged particle beam, for formation of latent image.

As explained above, according to the method of the present invention, problems in conventional techniques have been solved and the charge accumulation phenomenon in resist film during charged particle beam patterning can be reduced to improve accuracy of the pattern position, and besides highly integrated semiconductor devices can be obtained easily and in high yields.

Furthermore, according to the present invention, it is enough to form a layer of radiation-induced conductive resin composition as a bottom resist layer and no additional steps are required and this is economical.

### BRIEF DESCRIPTION OF THE DRAWINGS

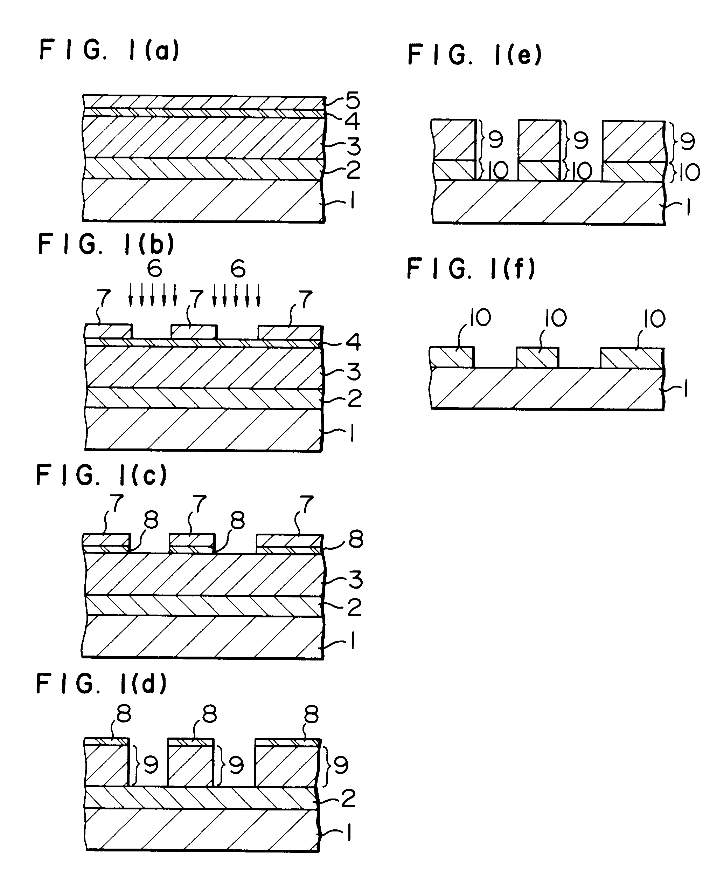

Fig. 1 (a)-(f) is a flow sheet which shows steps of processing in one example of the present invention.

### DETAILED DESCRIPTION OF PREFERRED EMBODIMENTS

### [Examples]

The present invention is explained in more detail by the following Examples.

### Example 1

Fig. 1 is a flow sheet which explains the steps of processing in one example of the present invention where a tri-layer resist process is used.

First, Fig. 1(a) shows a construction formed by coating a radiation-induced conductive resin film 3 (2.5 µm thick) on aluminum film 2 (1 µm thick) to be processed which was provided on semiconductor base 1 for forming a wiring layer, then spin-coatable silicate glass layer 4 was coated thereon to a thickness of 0.1 µm, followed by heat treatment at 200°C for 30 minutes and furthermore, positive electron-beam resist RE5000P (trademark for resist of Hitachi Chemical Co., Ltd.) 5 was coated to a thickness of 0.5 µm. The above radiation-induced conductive resin film 3 was formed by spin-coating on the base a cyclohexane solution of poly-N-vinylcarbazole prepared by cation polymerization and heat treating the coating at 230°C for 20 minutes on a hot plate.

Fig. 1(b) shows the state where the substrate obtained in Fig. 1(a) was wiring-patterned with electron-beam 6 at an acceleration voltage of 30 KV and a dose of 2 µC/cm by a variable shaped beam type electron-beam lithography system and then the resulting latent image was developed with an aqueous solution containing 2% by weight of tetramethylammonium hydroxide to obtain top-layer resist pattern 7.

Fig. 1(c) shows the state where the spin-coatable silicate glass film 4 of the substrate shown in Fig. 1(b) was subjected to etching in fluorine-containing plasma to obtain spin-coatable silicate glass pattern 8 corresponding to the top-layer resist pattern.

Fig. 1(d) shows the state where the radiation-induced conductive resin layer 3 of the substrate of Fig. 1(c) was subjected to reactive ion etching by oxygen plasma to obtain bottom-layer resist pattern 9 corresponding to the spin-coatable silicate glass pattern 8.

Fig. 1(e) shows the state where the spin-coatable silicate glass pattern 8 of the substrate of Fig. 1(d) was removed by dilute aqueous hydrofluoric acid solution and then aluminum film 2 was etched by reactive ion etching with chlorine to obtain aluminum wiring pattern 10.

Fig. 1(f) shows the state where the unnecessary bottom-layer resist pattern 9 of the substrate of Fig. 1(e) was removed by oxygen plasma to form aluminum wiring pattern 10.

As a comparative example, a sample was prepared by forming an aluminum wiring pattern on semiconductor base 1 in the same manner as above except that a resin layer of 2.5 µm thick obtained by coating a usual positive photoresist OFPR-800 (trademark for photoresist of Tokyo Oka Kogyo Co.) in place of the radiation-induced conductive resin and heat treating the coating at 230°C for 30 minutes was used as a bottom-layer resist.

Deviation in position when irradiation of the electron-beam was deflected by 6 mm was measured on these two samples. The latter sample, in which a usual positive photoresist was used, showed a deviation in position of 0.5 µm, while the former sample, in which the radiation-induced conductive resin composition according to the present invention was used, showed a deviation in position of only 0.05 µm or less.

Dry etching resistance of the aluminum film when the radiation-induced conductive resin composition was used as the bottom-layer resist was equivalent to that of the aluminum film when a bottom-layer resist obtained by coating the OFPR-800 and heat treating it at 230°C for 30 minutes.

### Example 2

Example 1 was repeated except that formation of the gate pattern was carried out using a polysilicon film in place of the aluminum wiring layer, thereby to obtain improvement in positional accuracy similar to that obtained in Example 1. In this case, etching of the polysilicon film was carried out by reactive ion etching with fluorine-containing plasma.

### Example 3

An aluminum wiring pattern was prepared in the same manner as in Example 1, except that the variable shaped beam type electron-beam lithography system used in Example 1 (which was remodeled to provide an ultraviolet ray projector in the patterning chamber) was used, and the surface of the sample substrate was exposed to ultraviolet ray emitted from a low-pressure mercury lamp through a photo-guide during electron-beam patterning. Positional accuracy of this pattern was examined to find that the accuracy was further improved to 0.04 µm or less in positional deviation.

### Example 4

The film comprising only the poly-N-vinylcarbazole used as the radiation-induced conductive resin layer in Example 1 had cracks on a part of the film surface after heat treatment. Therefore, for improving the quality of the film surface, various additives were examined and as a result, it was found that when the following additives were used alone or in combination, the film, after being subjected to heat treatment at 230°C for 20 minutes, became insoluble in solvent without developing any cracks on the surface and thus the quality of the film was improved: Naphthoquinonediazide derivatives such as ester of 1,2-naphthoquinone-(2)-diazide-5-sulfonic acid with 2,3,4-trihydroxybenzophenone and ester of said naphthoquinonediazidesulfonic acid with 4,4'-dihydroxydiphenyl-(2)-propane, diazide compounds such as 1-(4-azidobenzylidene)-3-(α-hydroxy-4-azidobenzyl)-indene, 4-4'-diazidocalcone, and 2,6-bis(4'-azidobenzal)cyclohexane, and epoxy resins such as bisphenol-A type epoxy resin (D,E,R-661 manufactured by Dow Chemical Co.) and epoxy novolak resin (TACTIX-485 manufactured by Dow Chemical Co.). Some examples of compositions of these mixed films are shown in Table 1 in % by weight.

**Table 1**

| | PVCz | NQD | EPX |
|---|---|---|---|
| Composition 1 | 90.0 | 10.0 | - |
| Composition 2 | 70.0 | 30.0 | - |
| Composition 3 | 50.0 | 50.0 | - |
| Composition 4 | 60.0 | 30.0 | 10.0 |
| Composition 5 | 50.0 | 25.0 | 25.0 |
| Composition 6 | 30.0 | 30.0 | 40.0 |

- PVCz:: Poly-N-vinylcarbazole.
- NQD:: 1,2-Naphthoquinone-(2)-diazide-5-sulfonic
- EPX:: Epoxy novolak resin TACTIX-485 manufactured by Dow Chemical Co.

Each of the compositions was dissolved in cyclohexanone to prepare coating solutions. An aluminum wiring layer was formed in the same manner as in Example 1, except that each of these coating solutions was used in place of PVCz cyclohexanone solution. All of the resulting samples showed remarkable improvement in positional accuracy as compared with the samples in which heat treated film of the usual positive photoresist was used as the bottom-layer resist.

In the above examples, explanation has been made on tri-layer resist construction in which a spin-coatable silicate glass was used as the middle layer.

## Claims

1. A method for forming a pattern by a multi-layer resist process, including the steps of:
(a) forming an organic bottom resist layer (3) comprising a radiation-induced conductive resin composition on a grounded conductive layer (2) on a semiconductor substrate (1),
(b) forming a coating film (4) containing silicate glass as a silicon-containing component on the bottom resist layer (3),
(c) forming an electron-beam top resist layer (5) as a mask for processing the coating film (4) into a pattern,
(d) irradiating the top resist layer (5) using a charged particle beam (6) thereby forming the pattern,
(e) developing the top resist layer thereby forming a top resist pattern (7),
(f) processing the coating film (4) through the top resist pattern (7), and
(g) processing the bottom resist layer (3) into a pattern by reactive ion etching of oxygen plasma with the patterned coating film (4) as a mask (8),
wherein the radiation-induced conductive resin composition of the bottom resist layer (3) contains 10 to 70 % by weight of an additive containing a cross-linking component.

2. A method according to claim 1, wherein the charged particle beam (6) is an electron beam.

3. A method according to claim 1, wherein irradiation with actinic radiation is carried out to increase the conductivity of the bottom resist layer (3) substantially simultaneously with the irradiation by the charged particle beam.

4. A method according to claim 3, wherein the actinic radiation is ultraviolet light, X-ray or infrared light which does not affect the charged particle beam system.

5. The method of any of claims 1 to 4, wherein the radiation-induced conductive resin composition comprises a vinyl polymer having an aromatic ring containing 10 to 16 π-electrons in the side chains.

6. The method of claim 5, wherein the aromatic ring contains a carbazole ring.

7. The method of any of claims 1 to 6, wherein the additive contains a cross-linking reactive component.

## Patentansprüche

1. Verfahren zum Ausbilden eines Musters mit Hilfe eines Mehrschicht-Resistvorgangs mit folgenden Schritten:
(a) Ausbilden einer organischen unteren Resistschicht (3), die eine durch Strahlung leitfähig zu machende Harzzusammensetzung enthält, auf einer auf einem Halbleitersubstrat (1) vorhandenen geerdeten leitenden Schicht (2),
(b) Ausbilden eines Beschichtungsfilms (4), der als siliciumhaltige Komponente Silikatglas enthält, auf der unteren Resistschicht (3),
(c) Ausbilden einer oberen Elektronenstrahl-Resistschicht (5) als Maske zur Bearbeitung des Beschichtungsfilms (4) in ein Muster,
(d) Bestrahlen der oberen Resistschicht (5) mit einem Strahl (6) aus geladenen Teilchen zur Erzeugung des Musters,
(e) Entwickeln der oberen Resistschicht zur Ausbildung eines oberen Resistmusters (7),
(f) Bearbeiten des Beschichtungsfilms (4) durch das obere Resistmuster (7) hindurch, und
(g) Bearbeiten der unteren Resistschicht (3) zu einem Muster durch reaktives Ionenätzen mit Sauerstoffplasma und unter Verwendung des aus dem Beschichtungsfilm (4) gebildeten Musters als Maske (8),
wobei die durch Strahlung leitfähig zu machende Harzzusammensetzung der unteren Resistschicht (3) 10 bis 70 Gew.-% eines eine Vernetzungskomponente enthaltenden Zusatzes aufweist.

2. Verfahren nach Anspruch 1, wobei der Strahl (6) aus geladenen Teilchen ein Elektronenstrahl ist.

3. Verfahren nach Anspruch 1, wobei im wesentlichen gleichzeitig mit der Bestrahlung mittels des Strahls geladener Teilchen eine Bestrahlung mit aktinischer Strahlung zur Erhöhung der Leitfähigkeit der unteren Resistschicht (3) vorgenommen wird.

4. Verfahren nach Anspruch 3, wobei die aktinische Strahlung ultraviolettes Licht, Röntgenstrahlen oder infrarotes Licht ist, das das System des Strahls geladener Teilchen nicht beeinflußt.

5. Verfahren nach einem der Ansprüche 1 bis 4, wobei die durch Strahlung leitend zu machende Harzzusammensetzung ein Vinylpolymer mit einem 10 bis 16 π-Elektronen enthaltenden aromatischen Ring in den Seitenketten aufweist.

6. Verfahren nach Anspruch 5, wobei der aromatische Ring einen Karbazolring enthält.

7. Verfahren nach einem der Ansprüche 1 bis 6, wobei der Zusatz eine reaktive Vernetzungskomponente enthält.

## Revendications

1. Procédé pour réaliser un motif à l'aide d'une technique par résist multicouche, comprenant les étapes consistant à:
(a) former une couche organique inférieure (3) de résist comportant, sur un substrat semiconducteur (1), une composition de résine rendue conductrice par un rayonnement et superposée à une couche conductrice (2) reliée à la terre,
(b) former, sur la couche inférieure (3) de résist, une pellicule de revêtement (4) contenant du verre de silicate en tant que constituant contenant du silicium,
(c) former une couche supérieure (5) de résist pour créer, à l'aide d'un faisceau d'électrons, un motif dans la pellicule de revêtement (4)
(d) irradier la couche supérieure (5) de résist à l'aide d'un faisceau (6) de particules chargées, en formant de ce fait le motif,
(e) développer la couche supérieure de résist en formant de ce fait un motif supérieur (7) de résist,
(f) traiter la pellicule de revêtement (4) à travers le motif supérieur (7) de résist, et
(g) créer un motif dans la couche inférieure (3) de résist par attaque par ions réactifs à l'aide d'un plasma d'oxygène, un masque (8) étant constitué par la pellicule de revêtement (4) dans laquelle est formé un motif,
sachant que la composition de résine de la couche inférieure (3) de résist, rendue conductrice par un rayonnement, contient de 10 à 70% en poids d'un additif contenant un agent de réticulation.

2. Procédé selon la revendication 1, dans lequel le faisceau (6) de particules chargées est un faisceau d'électrons.

3. Procédé selon la revendication 1, dans lequel une l'irradiation par rayonnement actinique est effectuée pour accroître la conductibilité de la couche inférieure (3) de résist sensiblement en même temps que l'irradiation par le faisceau de particules chargées.

4. Procédé selon la revendication 3, dans lequel le rayonnement actinique est de la lumière ultraviolette, des rayons X ou de la lumière infrarouge sans influence sur le système de gravure par faisceau de particules chargées.

5. Procédé selon l'une quelconque des revendications 1 à 4, dans lequel la composition de résine rendue conductrice par un rayonnement comporte un polymère vinylique ayant un noyau aromatique contenant 10 à 16 électrons D dans les chaînes latérales.

6. Procédé selon la revendication 5, dans lequel le noyau aromatique contient un noyau de carbazol.

7. Procédé selon l'une quelconque des revendications 1 à 6, dans lequel l'additif contient un agent réactif de réticulation.
